# EUROPEAN PATENT APPLICATION

(11) **EP 1 341 217 A2**
(43) Date of publication of application: **03.09.2003**
(21) Application number: 02257345.5
(22) Date of filing: 23.10.2002
(51) Int. Cl.: H01L 21/02

(54) **Capacitor for semiconductor device, manufacturing method thereof, and electronic device employing the same**

(30) Priority: 28.02.2002 KR 2002010982
(71) Applicant: SAMSUNG ELECTRONICS CO., LTD., Suwon-City, Kyungki-do (KR)
(72) Inventor: Lee, Jung-hyun, Suwon-city, Kyungki-do, 442-470 (KR); Min, Yo-sep, Dongjak-gu, seoul (KR); Cho, Young-jin, Bupyeong-gu, Incheon (KR)
(74) Representative: Greene, Simon Kenneth

(57) **Abstract**

A capacitor for use in a semiconductor device, a method of fabricating the capacitor, and an electronic device adopting the capacitor are provided. The capacitor includes upper and lower electrodes, each formed of a platinum group metal; a thin dielectric layer disposed between the upper and lower electrodes; and a buffer layer disposed between the lower electrode and the thin dielectric layer, the buffer layer including a metal oxide of Group 3, 4, or 13.

## Description

The present invention relates to a capacitor for a semiconductor device, and more particularly, to a capacitor for use in a semiconductor device, which can effectively suppress the oxidization of a material for an electrode, when forming a thin dielectric layer, a manufacturing method thereof, and an electronic device that employs the capacitor and thus can be highly integrated.

The more integrated memory is, the smaller the size of a unit cell and the smaller the area of a capacitor. Thus, to realize a capacitor having a large electrostatic capacity in a limited area, extensive research into the use of a capacitor dielectric having a large permittivity, which triggers a need for a high-dielectric material, such as tantalum oxide (TaO) and strontium titanium oxide (SrTiO₃), which have a larger permittivity than a low-dielectric material such as SiO₂ and Si₃N₄, has been conducted.

However, despite the use of such a high-dielectric material, a three-dimensional capacitor is required to realize a capacitor having a large capacity. To this end, an atomic layer deposition (ALD) method is used.

According to the ALD method, a desired metal oxide thin dielectric film is obtained by chemically absorbing an organometallic compound, which is a precursor, on a substrate, and processing the thin film under an oxygen atmosphere. The ALD method is advantageous in that an organic substance included in a precursor can be removed by a strong oxidizer since the precursor and the oxidizer are introduced using time division.

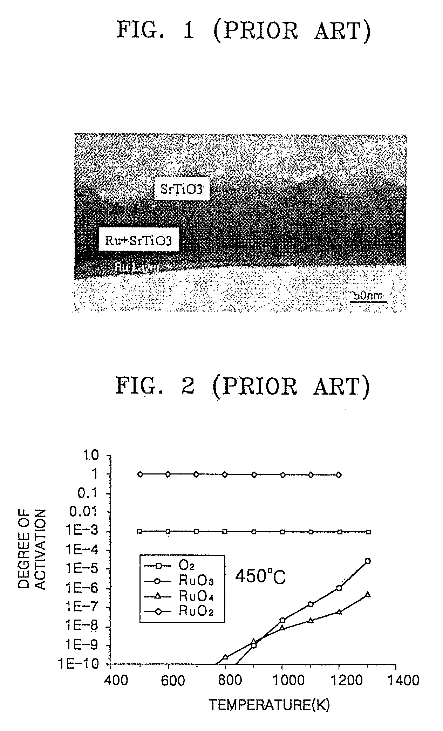

However, if a lower electrode, which is to be formed below a thin dielectric layer when forming an atomic layer, is formed of a material that is prone to oxidization, e.g., ruthenium (Ru), the Ru electrode may be deformed and the thin dielectric layer may deteriorate, as shown in FIG. 1. Therefore, the thin dielectric layer is difficult to highly integrate.

FIG. 1 is a view of a capacitor in which a thin strontium titanium oxide (SrTiO₃) layer is formed on a Ru lower electrode by a conventional O₃ atomic layer deposition (ALD) method. Referring to FIG. 1, it is noted that a protrusion of the Ru lower electrode is caused in the capacitor.

As shown in FIG. 2, Ru easily changes into RuO₂ or RuO₄ under an oxygen atmosphere, which causes the deformation of the Ru electrode.

According to the invention there is provided a capacitor for use in a semiconductor device, including upper and lower electrodes, each formed of a platinum group metal; a thin dielectric layer disposed between the upper and lower electrodes; and a buffer layer disposed between the lower electrode and the thin dielectric layer, the buffer layer including a metal oxide of Group 3, 4, or 13.

Thus, the invention may provide a capacitor for use in a semiconductor device, in which the oxidization of a material for an electrode is effectively suppressed when forming a thin dielectric layer.

In another aspect, there is provided a method of fabricating such a capacitor for use in a semiconductor device, including: forming a buffer layer on a lower electrode of a platinum group metal by performing an atomic layer deposition (ALD) process using a precursor for the buffer layer; forming a thin dielectric layer by performing the ALD process using a precursor for a thin dielectric layer on the buffer layer; and forming an upper electrode of a platinum group metal on the thin dielectric layer.

In still another aspect, there is provided a method of fabricating such a capacitor for use in a semiconductor device, including: absorbing CO on a surface of a lower electrode of a platinum group metal; placing the lower electrode under a reducing atmosphere to produce a lattice oxygen; forming a thin dielectric layer by performing an ALD process using a precursor for the thin dielectric layer, using the lattice oxygen; and forming an upper electrode of a platinum group metal on the thin dielectric layer.

In yet another aspect, there is provided an electronic device employing the capacitor above for a semiconductor device. This device may accordingly integrate a thin dielectric layer.

The above object and advantages of the present invention will become more apparent by describing in detail a preferred embodiment thereof with reference to the attached drawings in which:
FIG. 1 is a view of a capacitor formed by a conventional O₃ atomic layer deposition (ALD) method;
FIG. 2 is a graph illustrating variations in the degree of activation of ruthenium (Ru) oxide in the capacitor of FIG. 1, according to a temperature;
FIG. 3 is a view explaining a process of how carbon monoxide (CO) absorbed on the surface of a Ru electrode changes into a lattice oxygen, according to the present invention;
FIGS. 4A through 4C are cross-sectional views showing embodiments of a memory device employing a capacitor according to the present invention;
FIG. 5 is a photograph of an SrTiO₃ thin layer of a capacitor according to one embodiment of the present invention, taken by a transmission electron microscope (TEM);
FIG. 6 is a photograph of an SrTiO₃ thin layer of a capacitor according to another embodiment of the present invention, taken by a scanning electron microscope (SEM); and
FIGS. 7A and 7B are graphs illustrating the electrical characteristics of a capacitor according to still another embodiment of the present invention.

In the present invention, a buffer layer is formed between a thin dielectric layer and an electrode so as to prevent the oxidization of a platinum metal, especially, ruthenium (Ru), which is a material for an electrode, when forming the thin dielectric film. The buffer layer is formed of a metal oxide of Group 3, 4, or 13, preferably, at least one selected from TiO₂, Al₂O₃, Ta₂O₅, and HfO₂. Such a buffer layer may be formed by an atomic layer deposition (ALD) of a precursor for forming the buffer layer. The precursor is an organometallic compound having a small sized ligand or that is easily decomposed when being absorbed on a substrate and causes the chemical absorption of a by-product. The use of such an organometallic compound allows an atomic layer of a higher packing density to be formed on an electrode.

A metal precursor includes Ti(i-OPr)₄ or Ti(l-OPr)₂(tmhd)₂ for TiO₂ buffer layer *(tmhd* indicates tetramethylheptanedionate, and *i-OPr* indicates isopropoxy); Al(CH₃)₃ or AlCl₃ for an Al₂O₃ buffer layer; Ta(OEt)₅ *(OEt* indicates ethoxide) for a Ta₂O₅ buffer layer; and HfCl₄, Hf(OBu)₄ for an HfO₂ buffer layer.

As described above, if an atomic layer having a high packing density is formed on an electrode, the surface of a Ru electrode is not directly in contact with ozone (O₃) or oxygen when a thin dielectric layer is formed. Further, it is possible to prevent the deformation of the electrode or the deterioration of the characteristics of a thin dielectric layer casued by the oxidization of the electrode.

The vapor deposition temperature of the precursor for a buffer layer depends largely on the characteristics of the precursor but preferably is 200 - 500°C. This is because the reactivity between the precursor and O₃, which is used as an oxidizer, is lowered where the deposition temperature is less than 200°C, and the precursor is decomposed so as not to form a buffer layer using ALD method if the deposition temperature is greater than 500°C.

Hereinafter, a method of fabricating a capacitor for use in a semiconductor device will be described.

First, a lower electrode is formed of a platinum group metal. At least one element is selected, as the platinum group metal, from the group consisting of ruthenium (Ru), osmium (Os), iridium (Ir), and platinum (Pt).

Then, a buffer layer is formed by performing the ALD process using a precursor for a buffer layer on the lower electrode.

Thereafter, a thin dielectric layer is formed by performing the ALD process using a precursor for a thin dielectric layer on the buffer layer. Preferably, the thin dielectric layer is formed of SrTiO₃, BaTiO₃, Pb(Zr,Ti)O₃, or the like. To make the thin dielectric layer of SrTiO₃, one of Sr(tmhd)₂ or Sr(methd)₂ *(methd* indicates methoxyethoxy tetramethylheptanedionate) is selected as Sr source, one of TiO(tmhd)₂ or TiO(l―OPr)₂(tmhd)₂ is selected as Ti source, and then the selected elements are mixed together. Next, the ALD process is performed using the precursor for the thin dielectric layer and oxygen gas or heat source. Preferably, the vapor deposition temperature of an atomic layer is 300 - 500°C.

Then, the capacitor for use in a semiconductor device according to the present invention is completed by forming an upper electrode on the thin dielectric layer using a platinum group metal.

In the present invention, a lattice oxygen obtained from carbon monoxide (CO) that is absorbed in a material for an electrode is used as an oxidation.

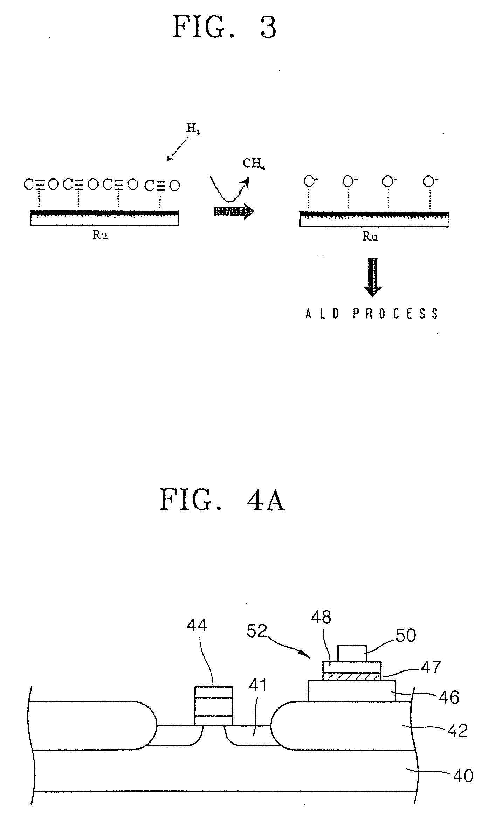

FIG. 3 is a view explaining a process of producing lattice oxygen when a Ru electrode is adopted. Referring to FIG. 3, where CO absorbed on the Ru electrode is placed under a reducing atmosphere and the carbon in the CO is removed in the form of CH₄. Thus, only lattice oxygen remains on the surface of Ru electrode, which is used as an oxidizer when a thin dielectric layer is formed by the ALD process during a subsequent process.

A method of fabricating a capacitor for use in a semiconductor device according to the present invention, using the lattice oxygen, will now be described.

First, CO is absorbed on the surface of a lower electrode made of an element of a platinum group metal. Next, the resultant is placed under a reducing atmosphere to produce lattice oxygen. To this end, the temperature can be maintained at 100 - 500°C. This is because CO is difficult to reduce if the temperature is lower than 100°C, and CO is eariler desorbed from the surface of a lower electrode carbon if the process temperature is higher than 500°C. The reducing atmosphere is formed using a reducing gas such as hydrogen.

Thereafter, a thin dielectric layer is formed by performing the ALD process using a precursor for a thin dielectric layer, using the lattice oxygen. a method of forming the thin dielectric layer and the required materials are as described above.

Then, a capacitor for use in a semiconductor device according to the present invention is completed by forming an upper electrode from an element of a platinum group metal on the thin dielectric layer.

Such a capacitor can be applied to various electronic devices such as a dynamic RAM (DRAM) device and non-volatile memory (FRAM).

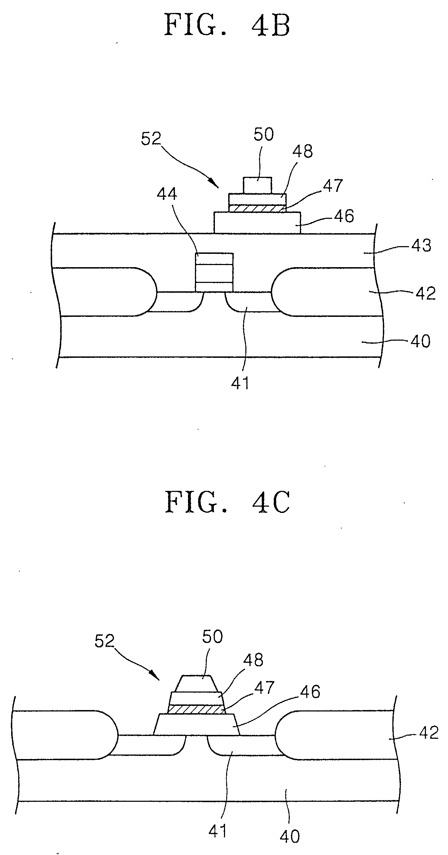

FIGs. 4A through 4C are cross-sectional views of several forms memory devices adopting a capacitor according to the present invention. More specifically, FIG. 4A is a cross-sectional view of a memory device of a single transistor type, FIG. 4B is a cross sectional view of a 1Tr-1C type memory device, and FIG. 4C is a cross sectional view of a 1Tr-1C COB-type memory device.

In FIGs. 4A-4C, reference numerals '40' denotes a silicon substrate; '41', an active region; '42', a non-active region; '43', a lower structure; '44', a gate electrode; '45', a polysilicon layer; '46', a lower electrode; '47', a buffer layer of TiO₂; '48', a thin dielectric layer of SrTiO₃; '50', an upper electrode; and '52', a capacitor.

In FIGS. 4A through 4C, various memory devices adopting a preferred embodiment of a capacitor according to the present invention are illustrated, but such a capacitor can be applied to other electronic devices having a thin dielectric layer.

Hereinafter, a capacitor according to the present invention will be specifically described by the following exemplary embodiments.

### <First Embodiment>

An atomic layer deposition (ALD) process was performed at about 325°C using 0.1M of Ti(i-OPr)₂(tmhd)₂ dissolved in tetrahydrofuran (THF) and using O₃ as an oxidizer to form a buffer layer of TiO₂ on a first Ru electrode.

Then, the ALD process was performed on the buffer layer at about 400°C, using Sr(mdthd)₂ and Ti(i-OPr)₂(tmhd)₂ as a precursor and O₃ as an oxidizer to form a thin dielectric layer of SrTiO₃.

Next, a second Ru electrode was formed on the thin dielectric layer of SrTiO₃, thereby completing a capacitor.

### <Second Embodiment>

A capacitor was prepared in the same manner as in the first embodiment, except that the ALD process was performed at about 400°C with Al(CH₃)₃ as a precursor for a buffer layer and O₃ as an oxidizer to form a buffer layer of Al₂O₃ on a second Ru electrode.

### <Third Embodiment>

CO was absorbed on the surface of a first Ru electrode and processed under hydrogen gas atmosphere at about 400°C to produce lattice oxygen. Then, a thin dielectric layer of SrTiO₃ was prepared in the same manner as in the first embodiment.

Then, a second Ru electrode was formed on the thin dielectric layer of SrTiO₃, thereby completing a capacitor.

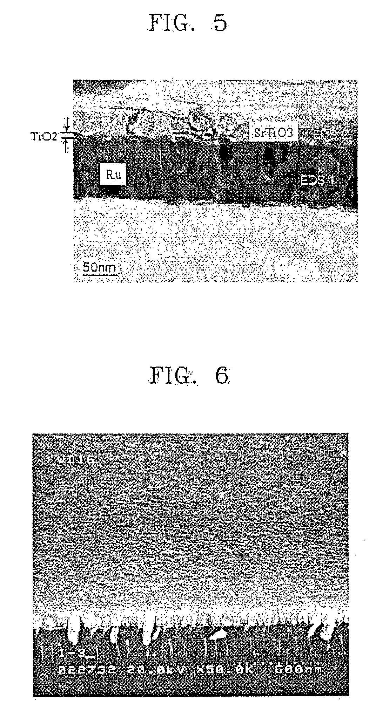

The laminated cross-section of a thin dielectric layer of SrTiO₃ formed on the Ru thin layer according to the first embodiment is taken by a transmission electronic microscope (TEM) as illustrated in FIG. 5.

Referring to FIG. 5, the buffer layer of TiO₂ is formed below the thin layer of SrTiO₃, and the Ru electrode is positioned under the buffer layer of TiO₂. It is noted that a protrusion is not formed in the Ru electrode.

FIG. 6 is a photograph of the laminated cross-section of the thin dielectric layer of SrTiO₃ formed on the Ru thin layer according to the second embodiment, taken by a scanning electronic microscope (SEM).

From FIG. 6, it is noted that, due to the buffer layer, a protrusion does not occur in the Ru electrode, and the roughness of the surface of the capacitor does not increase when a thin dielectric layer of SrTiO₃ is deposited.

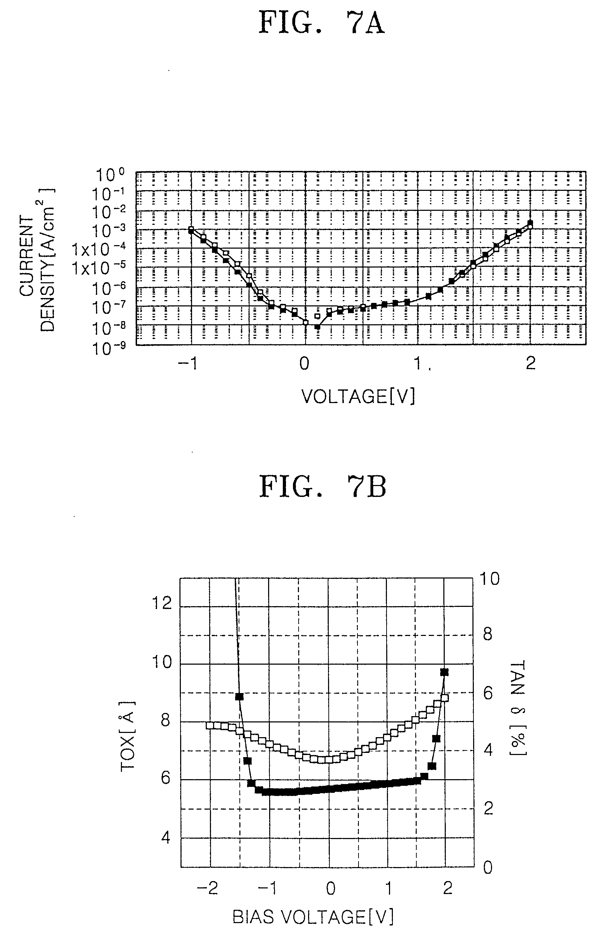

FIGs. 7A and 7B are graphs illustrating the electrical characteristics of the capacitor according to the third embodiment. More specifically, FIG. 7A shows variations in the density of electric current according to voltage. FIG. 7A reveals that 10⁻⁷A/cm² at 1V, which is the standard set for a DRAM, is generally satisfied by the capacitor prepared in the third embodiment. FIG. 7B shows variations in tox according to bias voltage. Here, the 'tox' is referred to as a value that is the thickness of a thin dielectric layer calculated in the thickness of SiO₂. The smaller the value of tox, the better the quality of a dielectric layer. Referring to FIG. 7B, the tox of a dielectric layer is 6.8 Å just after the deposition thereof, and is 7Å, which is the tox of the dielectric layer required for a DRAM of more than 16G.

While this invention has been particularly described with reference to preferred embodiments thereof, it will be understood by those skilled in the art that various changes in form and details may be made therein without departing from the spirit and scope of the invention as defined by the appended claims.

As described above, in a capacitor according to the present invention, the oxidization of a Ru electrode, which is a lower electrode, can be suppressed even when forming a thin dielectric layer by performing the ALD process with a strong oxidizer such as O₃, thereby preventing the deformation of the Ru electrode and the deterioration of the characteristics of the thin dielectric layer. Accordingly, a capacitor according to the present invention can secure the excellent electrical characteristics of a thin dielectric layer, which is required by a highly integrated memory, and therefore can be available in an electronic device such as a DRAM.

## Claims

1. A capacitor for use in a semiconductor device comprising:
upper and lower electrodes, each formed of a platinum group metal;
a thin dielectric layer disposed between the upper and lower electrodes; and
a buffer layer disposed between the lower electrode and the thin dielectric layer, the buffer layer including a metal oxide of Group 3, 4, or 13.

2. The capacitor of claim 1, wherein the metal oxide of Group 3, 4, or 13 is at least one selected from the group consisting of TiO₂, Al₂O₃, Ta₂O₅, and HfO₂.

3. The capacitor of claim 1 or 2, wherein the thin dielectric layer comprises SrTiO₃, BaTiO₃, or Pb(Zr,Ti)O₃.

4. The capacitor of claim 1, 2 or 3, wherein the platinum metal is at least one selected from the group of Ru, Os, Ir, and Pt.

5. A method of fabricating a capacitor for use in a semiconductor device, the method comprising:
forming a buffer layer on a lower electrode of a platinum group metal by performing an atomic layer deposition (ALD) process using a precursor for the buffer layer;
forming a thin dielectric layer by performing the ALD process using a precursor for a thin dielectric layer on the buffer layer; and
forming an upper electrode of a platinum group metal on the thin dielectric layer.

6. The method of claim 5, wherein the precursor for the buffer layer comprises Ti(i-OPr)₂(tmhd)₂ *(tmhd* indicates tetramethylheptanEdionate, and *i-OPr* indicates isopropoxy), Al(CH₃)₃ or Hf(OBu)₄ *(n-OBu* indicates n-butoxide).

7. The method of claim 5 or 6, wherein the ALD process for forming the buffer layer is performed at a temperature of 200 - 500°C.

8. The method of claim 5, wherein the precursor for the thin dielectric layer comprises at least one selected from the group consisting of Sr(tmdh)₂, Sr(methd)₂, TiO(tmhd)₂, and Ti(i-OPr)₂(tmhd)₂.

9. A method of fabricating a capacitor comprising:
absorbing CO on a surface of a lower electrode of a platinum group metal; placing the lower electrode under a reducing atmosphere to produce a lattice oxygen;
forming a thin dielectric layer by performing an ALD process using a precursor for the thin dielectric layer, using the lattice oxygen; and
forming an upper electrode of a platinum group metal on the thin dielectric layer.

10. The method of claim 9, wherein the precursor for the thin dielectric layer comprises at least one selected from the group consisting of Sr(tmdh)₂, Sr(methd)₂, TiO(tmdh)₂, and Ti(i-OPr)₂(tmdh)₂.

11. The method of claim 9, wherein the reducing atmosphere is maintained at a temperature of 100 - 500°C.

12. An electronic device adopting a capacitor for a semiconductor device according to any of claims 1 to 4.

13. The electronic device of claim 12 being a dynamic RAM (DRAM) or non-volatile memory (FRAM).
